# FASCICULE DE BREVET EUROPEEN

(11) **EP 4 136 682 B1**
(45) Date de publication et mention de la délivrance du brevet: **27.03.2024**
(21) Numéro de dépôt: 21726145.2
(22) Date de dépôt: 09.04.2021
(51) Int. Cl.: H01L 33/20, H01L 33/02, H01L 33/16, H01L 33/32

(54) **DIODE ELECTROLUMINESCENTE COMPRENANT UNE STRUCTURE HYBRIDE FORMEE DE COUCHES ET DE NANOFILS**
ELEKTROLUMINESZENZDIODE MIT EINER AUS SCHICHTEN UND NANODRÄHTEN GEBILDETEN HYBRIDSTRUKTUR
ELECTROLUMINESCENT DIODE COMPRISING A HYBRID STRUCTURE FORMED OF LAYERS AND NANOWIRES

(30) Priorité: 15.04.2020 FR 2003746
(43) Date de publication de la demande: 22.02.2023
(73) Titulaire: Commissariat à l'énergie atomique et aux énergies alternatives, 75015 Paris (FR); CENTRE NATIONAL DE LA RECHERCHE SCIENTIFIQUE, 75794 Paris Cedex 16 (FR); UNIVERSITÉ GRENOBLE ALPES, 38400 Saint-Martin-d'Heres (FR)
(72) Inventeur: DAUDIN, Bruno, 38054 GRENOBLE CEDEX 09 (FR); JACOPIN, Gwénolé, 38042 GRENOBLE (FR); PERNOT, Julien, 38042 GRENOBLE (FR)
(74) Mandataire: Brevalex
(86) Numéro de dépôt international: PCT/FR2021/050630
(87) Numéro de publication internationale: WO 2021/209702

(56) Documents cités:
- EP-A1- 2 242 120
- EP-A1- 3 413 359
- WO-A1-2017/216445
- ALEXANDRA-MADALINA SILADIE ET AL: "Mg and In Codoped p-type AlN Nanowires for pn Junction Realization", NANO LETTERS, vol. 19, no. 12, 14 novembre 2019 (2019-11-14), pages 8357-8364, XP055710343, US ISSN: 1530-6984, DOI: 10.1021/acs.nanolett.9b01394 cité dans la demande

## Description

### DOMAINE TECHNIQUE

L'invention concerne le domaine des diodes électroluminescentes, ou LEDs (« Light-Emitting Diodes » en anglais). Avantageusement, l'invention s'applique à la réalisation de LEDs émettant une lumière dans le domaine ultra-violet (UV), notamment dans la gamme des longueurs d'onde comprises entre environ 200 nm et 350 nm.

### ÉTAT DE LA TECHNIQUE ANTÉRIEURE

Dans le domaine de l'émission lumineuse UV, il existe un besoin de trouver des solutions d'émission lumineuse ne faisant pas appel à du mercure. Les LEDs composées d'alliage d'AIN et de GaN sont une solution à ce problème.

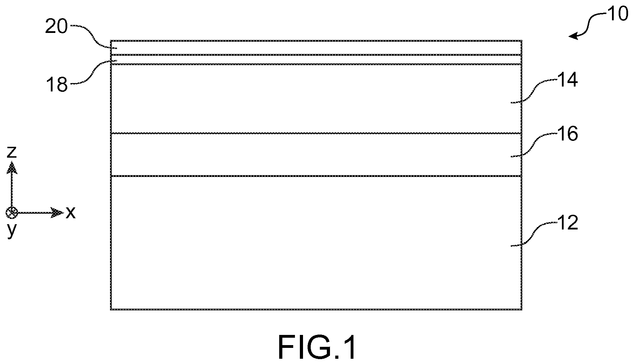

Les LEDs à base d'hétérostructures semi-conductrices émettant dans le domaine UV sont constituées d'un empilement de couches comprenant de l'AIGaN de différentes compositions. La figure 1 représente schématiquement la structure d'une telle LED 10. La LED 10 comporte une jonction p-n formée par une première couche 12 comprenant de l'AIGaN dopé n et une deuxième couche 14 comprenant de l'AIGaN dopé p. La LED 10 comporte également, entre les couches 12 et 14, une zone active 16 formant la région émissive de la LED 10 et comprenant des puits quantiques dans lesquels se produisent les recombinaisons d'électrons et de trous d'électrons qui engendrent l'émission de photons. La zone active 16 comprend de l'AIGaN non dopé intentionnellement, ou intrinsèque. La LED 10 comporte également, sur la deuxième couche 14, une couche 18 de GaN fortement dopé p, ainsi qu'une couche 20 électriquement conductrice disposée sur la couche 18 et comportant par exemple un alliage Ni-Au. Ces couches sont formées par MOCVD (« Metal Organic Chemical Vapor Déposition » en anglais, ou dépôt chimique en phase vapeur à partir de précurseurs métal-organiques).

La composition du semi-conducteur de la zone active 16 est choisie en fonction des longueurs d'onde destinées à être émises par la LED 10. Pour émettre dans le domaine UV, la zone active 16 comporte de l'Al_{X}Ga_{(1-X)}N, avec X tel que 0 ≤ X ≤ 1. La première couche 12 comporte de l'Al_{Y1}Ga_{(1-Y1)}N dopé n, et la deuxième couche 14 comporte de l'Al_{Y2}Ga_{(1-Y2)}N dopé p, avec Y₁ > X et Y₂ > X.

Idéalement, réaliser les couches 12 et 14 avec de l'AIN (c'est-à-dire réalisées telles que Y₁ = 1 et Y₂ = 1) permettrait de simplifier la réalisation de la LED 10. Toutefois, la réalisation de la deuxième couche 14 dopée p avec de l'AIN pose un problème car il n'existe pas de solution technique permettant d'obtenir de l'AIN avec un niveau de dopage de type p assez grand pour assurer une conduction électrique suffisante et nécessaire au bon fonctionnement de la LED 10. Les couches 12 et 14 sont donc actuellement réalisées telles que Y₁ < 1 et Y₂ < 1.

De plus, pour atteindre des longueurs d'onde importantes du domaine UV, par exemple de l'ordre de 300 nm ou moins, les couches 12 et 14 doivent comporter une forte concentration d'aluminium (par exemple supérieure à environ 60 %), ce qui pose un problème pour la réalisation du dopage p de la couche 14.

Enfin, l'injection de courant qui doit être réalisée du côté de la couche 14 de la LED 10 est une autre contrainte importante à considérer.

Ces problèmes sont actuellement résolus grâce à la présence de la couche 18 de GaN fortement dopé p dont l'épaisseur est de quelques dizaines de nanomètres et qui permet d'assurer la transition entre les couches 14 et 20. Mais l'absorption du rayonnement UV (notamment pour les longueurs d'onde inférieures à environ 350 nm) émis depuis la zone active 16 par cette couche 18 limite l'efficacité de la LED 10. En particulier, les LEDs émettant des longueurs d'onde comprises entre environ 250 nm et 260 nm et utilisées pour des applications bactéricides voient leur efficacité intrinsèquement diminuée par l'absorption d'une partie du rayonnement émis par la couche 18 de GaN fortement dopé p.

De plus, le dépôt de la couche 20, nécessaire pour assurer une bonne répartition latérale des lignes de courant et optimiser l'injection de courant du côté de la couche 14 de la LED 10, contribue à dégrader davantage encore l'efficacité d'émission de la LED 10 du fait que cette couche 20 absorbe une partie de la lumière UV émise depuis la zone active 16.

Le document « Mg and In Codoped p-type AIN Nanowires for pn Juntion Realization » de A-M Siladie et al., Nano Letters 2019 19 (12), 8357-8364, propose la réalisation d'une jonction p-n comportant des nanofils d'AIN dans lesquels il est possible de réaliser un important dopage p grâce à l'utilisation d'atomes de magnésium. De tels nanofils sont réalisés par croissance sur un substrat de silicium. Ces nanofils comportent également, dans leur partie supérieure, du GaN dopé p. Les nanofils sont recouverts d'une couche d'ITO (oxyde d'indium et d'étain) déposée au-dessus des parties de GaN dopé p des nanofils et servant de contact ohmique. Si une telle jonction p-n était utilisée pour réaliser une LED UV qui serait alors en nanofils, cette LED réalisée avec une couche de contact ohmique en ITO ne serait pas optimale car de l'ITO pourrait se retrouver entre les nanofils, ce qui peut créer des courts-circuits entre les parties dopées n et p des nanofils.

EP 3 413 359 A1 et EP 2 242 120 A1 divulguent des diodes électroluminescentes selon l'art antérieur.

### EXPOSÉ DE L'INVENTION

Un but de la présente invention est de proposer une diode électroluminescente dont la structure évite la création de courts-circuits dus à la couche de contact ohmique formée au sommet de la LED.

Pour cela, la présente invention propose une diode électroluminescente comportant au moins :
- une première couche d'Al_{X1}Ga_{(1-X1-Y1)}In_{Y1}N dopé n, avec X1 > 0 et X1+Y1 < 1 ;
- une deuxième couche d'Al_{X2}Ga_{(1-X2-Y2)}In_{Y2}N dopé p, avec X2 > 0 et X2+Y2 < 1 ;
- une zone active disposée entre les première et deuxième couches et comprenant au moins une structure émissive à multi-puits quantiques ;
- des nanofils à base d'AIN dopé p par des atomes d'indium et de magnésium, disposés sur la deuxième couche ;
- une couche de contact ohmique en contact avec les nanofils.

Une telle LED comporte donc une structure hybride formée d'un empilement de couches et de nanofils à base d'AIN dopé p disposés sur cet empilement de couches. Avec une telle structure, les courts-circuits dus à la couche de contact ohmique formée au sommet de la LED sont évités car le matériau de cette couche de contact ohmique ne peut pas être en contact à la fois avec les nanofils et avec le matériau de la première couche grâce à la présence de la deuxième couche.

Un autre avantage offert par la présente invention est la réalisation de diodes électroluminescentes (ou LED) dont la structure hybride peut améliorer l'extraction des photons grâce à la réalisation d'un réseau organisé de nanofils.

En outre, les nanofils à base d'AIN dopé p par des atomes d'indium et de magnésium, disposés sur la deuxième couche, permettent d'assurer une bonne répartition latérale des lignes de courant et optimiser l'injection de courant du côté de la couche dopée p de la LED, tout en limitant l'absorption lumineuse de ce côté de la LED.

La structure à multi-puits quantique de la zone active peut correspondre à une ou plusieurs couches de boîtes quantiques chacune formée d'une couche émissive disposée entre deux couches barrières.

Dans tout le texte, l'expression « nanofil à base d'AIN » désigne un nanofil pouvant comporter, en plus de l'AIN, une fraction molaire d'au moins un autre matériau comprise entre 0 et 30 %. Cet ou ces autres matériaux correspondent par exemple à du GaN, de l'InN ou du BN. Lorsque cet autre matériau correspond à de l'InN, la fraction molaire d'InN présente dans les nanofils à base d'AIN est de préférence inférieure ou égale à 20 %. De manière avantageuse, la fraction molaire du ou des matériaux, quels que soient ce ou ces matériaux, présents dans les nanofils à base d'AIN est de préférence inférieure ou égale à 5 %. L'expression « nanofil à base d'AIN » couvre également le cas de nanofils d'AIN, c'est-à-dire ne comportant pas de matériau autre que l'AlN.

Dans un premier mode de réalisation, la LED peut comporter en outre une couche diélectrique recouvrant des flancs latéraux des nanofils et sur laquelle repose la couche de contact ohmique.

Dans un deuxième mode de réalisation, la couche de contact ohmique peut recouvrir des flancs latéraux des nanofils et/ou des sommets des nanofils. Lorsque la couche de contact ohmique recouvre les flancs latéraux des nanofils, les nanofils peuvent être disposés dans la couche de contact ohmique. Cette configuration est avantageuse car la surface de contact entre la couche de contact ohmique et les nanofils est plus importante, ce qui améliore la répartition latérale des lignes de courant et l'injection de courant du côté de la couche dopée p de la LED.

De manière avantageuse, la couche de contact ohmique peut comporter du diamant.

La concentration atomique d'indium dans les nanofils peut être comprise entre environ 10¹⁷ et 10²¹ atomes/cm³ et/ou la concentration atomique de magnésium dans les nanofils peut être comprise entre environ 10¹⁸ et 10²¹ atomes/cm³.

Au moins une partie de l'épaisseur de la deuxième couche peut être gravée et peut former des piliers sur lesquels les nanofils peuvent être disposés.

La structure émissive à multi-puits quantiques peut comporter de l'Al_{X3}Ga_{(1-X3)}N, avec X3 compris entre environ 0 et 1, ou entre 0 et 0,9. Lorsque X3 = 1, la structure de la LED correspond à celle d'une jonction p-n qui peut être avantageuse pour réaliser une émission lumineuse à une longueur d'onde égale à 200 nm.

La diode électroluminescente peut comporter en outre une troisième couche d'Al_{X4}Ga_{(1-X4-Y4)}In_{Y4}N non dopé intentionnellement, avec X4 > 0 et X4+Y4 ≤ 1, telle que la première couche soit disposée entre la zone active et la troisième couche.

Les dimensions latérales des nanofils à l'interface avec la deuxième couche peuvent être inférieures à celles à l'interface avec la couche de contact ohmique.

Les nanofils peuvent avoir chacun une forme cylindrique ou, en variante, une autre forme comme par exemple une forme tronconique. Des nanofils de forme tronconique avec une section de dimensions plus importantes au sommet peuvent permettre de favoriser le dépôt de la couche de contact ohmique.

L'invention concerne également un procédé de réalisation d'une diode électroluminescente, comportant au moins :
- réalisation d'une première couche d'Al_{X1}Ga_{(1-X1-Y1)}In_{Y1}N dopé n, avec X1> 0 et X1+Y1 < 1 ;
- réalisation d'une zone active disposée sur la première couche et comprenant au moins une structure émissive à multi-puits quantiques ;
- réalisation d'une deuxième couche d'Al_{X2}Ga_{(1-X2-Y2)}In_{Y2}N dopé p, avec X2 > 0 et X2+Y2 ≤ 1, sur la zone active ;
- réalisation de nanofils à base d'AIN dopé p par des atomes d'indium et de magnésium, sur la deuxième couche ;
- réalisation d'une couche de contact ohmique en contact avec les nanofils.

La première couche, la zone active et la deuxième couche peuvent être réalisées par des dépôts de type MOCVD, et les nanofils peuvent être réalisés par épitaxie par jets moléculaires.

La couche de contact ohmique peut être réalisée, par exemple, par épitaxie par jets moléculaires, par évaporation sous vide, par pulvérisation cathodique, par dépôt chimique en phase vapeur (CVD, ou « Chemical Vapor Déposition » en anglais).

Selon une configuration particulière, la réalisation des nanofils peut comporter la mise en oeuvre des étapes suivantes :
- réalisation, sur la deuxième couche, d'un masque dur traversé par des ouvertures dont le nombre et la disposition correspondent au nombre et à la disposition des nanofils destinés à être réalisés ;
- réalisation des nanofils par épitaxie depuis les ouvertures du masque dur, sur la face de la deuxième couche sur laquelle le masque dur est disposé.

Selon une autre configuration particulière, la réalisation des nanofils peut comporter la mise en oeuvre des étapes suivantes :
- gravure mise en oeuvre dans au moins une partie de l'épaisseur de la deuxième couche et depuis une face de la deuxième couche du côté de laquelle les nanofils sont destinés à être réalisés, formant des piliers dont le nombre et la disposition correspondent au nombre et à la disposition des nanofils destinés à être réalisés ;
- réalisation des nanofils par épitaxie sur les piliers formés dans la deuxième couche.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente une LED de l'art antérieur et émettant dans le domaine UV ;
- les figures 2 à 5 représentent des LEDs à structure hybride comportant des couches de matériaux et des nanofils, objets de la présente invention, selon différents modes de réalisation ;
- les figures 6 à 9 représentent les étapes d'un premier procédé de réalisation d'une LED à structure hybride comportant des couches de matériaux et des nanofils, objet de la présente invention ;
- les figures 10 à 14 représentent les étapes d'un deuxième procédé de réalisation d'une LED à structure hybride comportant des couches de matériaux et des nanofils, objet de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

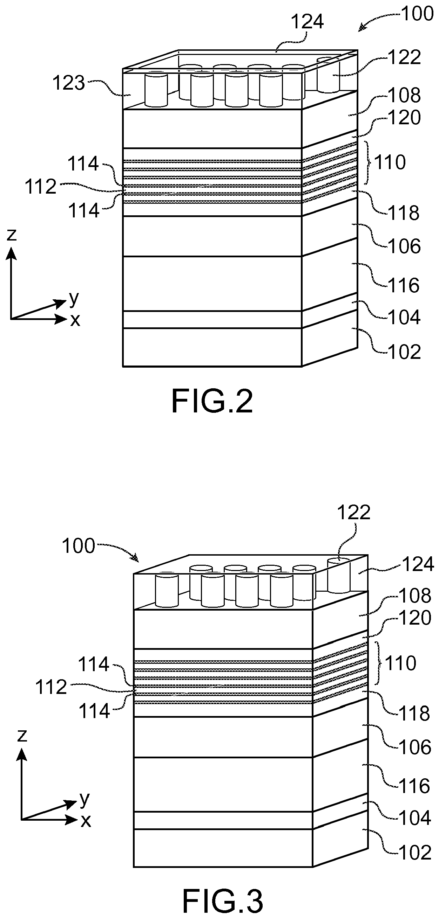

La figure 2 décrite ci-dessous représente une LED 100 à structure hybride formée de couches de matériaux et de nanofils, selon un premier mode de réalisation.

Dans la description ci-dessous, le terme « épaisseur » est utilisé pour désigner la dimension parallèle à l'axe Z, c'est-à-dire la dimension parallèle à la direction d'empilement des différentes couches de la LED 100.

La LED 100 comporte un substrat 102. Dans ce premier mode de réalisation, le substrat 102 comporte par exemple du saphir. D'autres types de substrat peuvent être utilisés, comprenant par exemple un matériau semi-conducteur tel que du silicium. L'épaisseur de ce substrat 102 est par exemple égale à plusieurs centaines de microns.

La LED 100 comporte également une couche tampon 104 disposée sur le substrat 102. La couche tampon 104 comporte de l'AIN. L'épaisseur de la couche tampon 104 est par exemple comprise entre environ 0,5 et 3 microns.

La LED 100 comporte une première couche 106 d'Al_{X1}Ga_{(1-X1-Y1)}In_{Y1}N dopé n, avec X1 > 0 et X1+Y1 ≤ 1. De préférence, la valeur de X1 est comprise entre environ 0,7 et 0,8 et la valeur de Y₁ est comprise entre environ 0 et 0,1. Avantageusement, la valeur de Y₁ est nulle, ce qui signifie que le semi-conducteur de la première couche 106 est de l'AIGaN. L'épaisseur de la première couche 106 est par exemple égale à 1 µm, ou comprise entre environ 0,5 µm et 5 µm.

Selon un exemple de réalisation, le dopage de type n du semi-conducteur de la première couche 106 est obtenu par incorporation d'atomes de silicium dans le semi-conducteur de la première couche 106 lors du dépôt de ce semi-conducteur. La concentration de dopants dans le semi-conducteur de la première couche 106 est par exemple comprise entre 10¹⁷ at/cm³ et 10¹⁹ at/cm³.

La LED 100 comporte également une deuxième couche 108 de semi-conducteur dopé p. Le semi-conducteur de la deuxième couche 108 correspond à de l'Al_{X2}Ga_{(1-X2-Y2)}In_{Y2}N dopé p, avec X2 > 0 et X2+Y2 ≤ 1. De manière avantageuse, le semi-conducteur de la deuxième couche 108 est tel que X2 = X1 et Y₂ = 0. Il est également possible et avantageux d'avoir X2 = 1. La concentration de dopants dans le semi-conducteur de la deuxième couche 108 est par exemple comprise entre environ 10¹⁸ at/cm³ et 10²¹ at/cm³. L'épaisseur de la deuxième couche 108 est par exemple égale à 1 µm, et plus généralement comprise entre environ 0,2 µm et 1 µm.

La LED 100 comporte également une zone active 110 disposée entre la première couche 106 et la deuxième couche 108. Cette zone active 110 comporte une structure émissive à multi-puits quantiques depuis lesquels une lumière est destinée à être émise. Cette structure émissive comporte une ou plusieurs couches émissives 112 chacune disposée entre deux couches barrières 114.

Les couches émissives 112 comportent un semi-conducteur correspondant par exemple à de l'Al_{X3}Ga_{(1-X3)}N, avec X3 tel que X3 < X2 et X1 et X3 de préférence compris entre 0 et 0,9. Ce semi-conducteur n'est pas intentionnellement dopé (ou intrinsèque), c'est-à-dire n'est pas soumis, lors de la réalisation de la LED 100, à une étape introduisant des atomes dopants dans le semi-conducteur. La concentration des atomes dopants résiduels présents dans ce semi-conducteur est par exemple comprise entre environ 10¹⁵ et 10¹⁷ atomes/cm³. L'épaisseur de chacune des couches émissives 112 est par exemple comprise entre environ 1 et 10 nm.

De manière avantageuse, la valeur de X3 est choisie telle que la longueur d'onde de la lumière émise depuis les couches émissives 112 de la zone active 110 appartienne au domaine de l'UV, notamment entre environ 210 nm et 340 nm, et plus particulièrement de l'UV-C (c'est-à-dire entre 210 nm et 280 nm), ce qui correspond à X3 tel que 0,7 < X3 < 1. Il est également possible que X3 soit compris entre 0 et 1 et lorsque X3 = 1, la structure de la LED est avantageuse pour réaliser une émission lumineuse à une longueur d'onde égale à 200 nm.

Les couches barrières 114 comportent également un semi-conducteur correspondant par exemple à de l'AIN ou de l'AlₓGa₁₋ₓN avec X > X3 et de préférence égal à X3 + 0,1. Comme le semi-conducteur des couches émissives 112, le semi-conducteur des couches barrières 114 n'est pas intentionnellement dopé. L'épaisseur de chacune des couches barrières 114 est par exemple comprise entre environ 1 nm et 10 nm.

L'épaisseur de la zone active 110 est par exemple égale à 100 nm, et plus généralement comprise entre environ 100 nm et 300 nm.

Dans l'exemple de réalisation qui correspond à la LED 100 visible sur la figure 2, la LED 100 comporte également une troisième couche 116 telle que la première couche 106 soit disposée entre la zone active 110 et la troisième couche 116. Cette troisième couche 116 comporte par exemple de l'Al_{X4}Ga_{(1-X4-Y4)}In_{Y4}N non dopé intentionnellement, avec X4 > 0 et X4+Y4 ≤ 1. De préférence, la valeur de X4 est comprise entre environ 0,3 et 0,7 et la valeur de Y4 est comprise entre environ 0 et 0,1. Il est également possible que la composition de la troisième couche 116 soit identique à celle de la première couche 106, ou bien que X4 soit par exemple égal à X1 - 0,1. L'épaisseur de la troisième couche 116 est par exemple comprise entre environ 500 nm et 2 microns. La concentration de dopants résiduels présents dans la troisième couche 116 est par exemple comprise entre environ 5.10¹⁵ et 5.10¹⁶ dopants/cm³.

En variante, il est possible que la LED 100 ne comporte pas la troisième couche 116.

Dans l'exemple de réalisation particulier représenté sur la figure 2, la LED 100 comporte également une couche 118 d'AlGaN non intentionnellement dopé disposée entre la première couche 106 et la zone active 110, et dont l'épaisseur est par exemple égale à 20 nm ou comprise entre environ 10 nm et 30 nm, ainsi qu'une couche 120 d'AlGaN non intentionnellement dopé disposée entre la deuxième couche 108 et la zone active 110, et dont l'épaisseur est par exemple égale à 20 nm ou comprise entre environ 10 nm et 30 nm, et servant de couche de blocage d'électrons pour éviter un surplus d'électrons dans la deuxième couche 108 et favoriser la recombinaison des porteurs de charge dans la zone active 110. En variante, la LED 100 peut ne pas comporter la couche 118.

Le LED 100 comporte également des nanofils 122 à base d'AIN dopé p réalisés sur la deuxième couche 108. Les caractéristiques géométriques de ces nanofils 122 sont par exemple un diamètre compris entre 50 nm et 100 nm, une densité de l'ordre de 10¹⁰ par cm², un espacement entre les centres des fils compris entre 100 nm et 200 nm, une hauteur comprise par exemple entre 100 nm et 1 micron.

Afin que le niveau de dopage p dans les nanofils 122 soit important, c'est-à-dire supérieur à environ 10²⁰ atomes/cm³, le matériau des nanofils 122 est dopé par des atomes d'indium et de magnésium. La concentration atomique d'indium dans les nanofils 122 est par exemple comprise entre environ 10¹⁷ et 10²¹ atomes/cm³, et la concentration atomique de magnésium dans les nanofils 122 est par exemple comprise entre environ 10¹⁸ et 10²¹ atomes/cm³. D'autres caractéristiques d'un tel dopage applicables à la LED 100 décrite ici sont décrites dans le document « Mg and In Codoped p-type AIN Nanowires for pn Juntion Realization » de A-M Siladie et al., Nano Letters 2019 19 (12), 8357-8364.

La LED 100 comporte également une couche diélectrique 123 formée autour des nanofils 122, comportant par exemple du SiO₂. La couche diélectrique 123 ne recouvre pas les sommets des nanofils 122 afin que les nanofils 122 soient accessibles électriquement depuis leur sommet.

Enfin, la LED 100 comporte une couche de contact ohmique 124 disposée sur les sommets des nanofils 122 et reliée électriquement à ces nanofils 122. Cette couche de contact ohmique 124 comporte au moins un matériau électriquement conducteur et transparent aux longueurs d'onde destinées à être émise par la LED 100, comme par exemple de l'ITO ou avantageusement du diamant.

La figure 3 décrite ci-dessous représente une LED 100 à structure hybride comportant des couches de matériaux et des nanofils, selon un deuxième mode de réalisation.

Par rapport à la LED 100 selon le premier mode de réalisation précédemment décrit, la LED 100 selon ce deuxième mode de réalisation comporte une couche de contact ohmique 124 qui recouvre les sommets des nanofils 122 et qui est également déposée entre les nanofils 122, sur la deuxième couche 108, en recouvrant les flancs latéraux des nanofils 122. Une telle couche de contact ohmique 124 est par exemple obtenue en déposant le matériau de cette couche perpendiculairement à la surface de la deuxième couche 108 sur laquelle les nanofils 122 sont disposées. Une telle couche de contact ohmique 124 est avantageuse car la surface de contact entre elle et les nanofils 122 est plus importante que dans le premier mode de réalisation. Dans ce deuxième mode de réalisation, la LED 100 ne comporte pas la couche diélectrique 123.

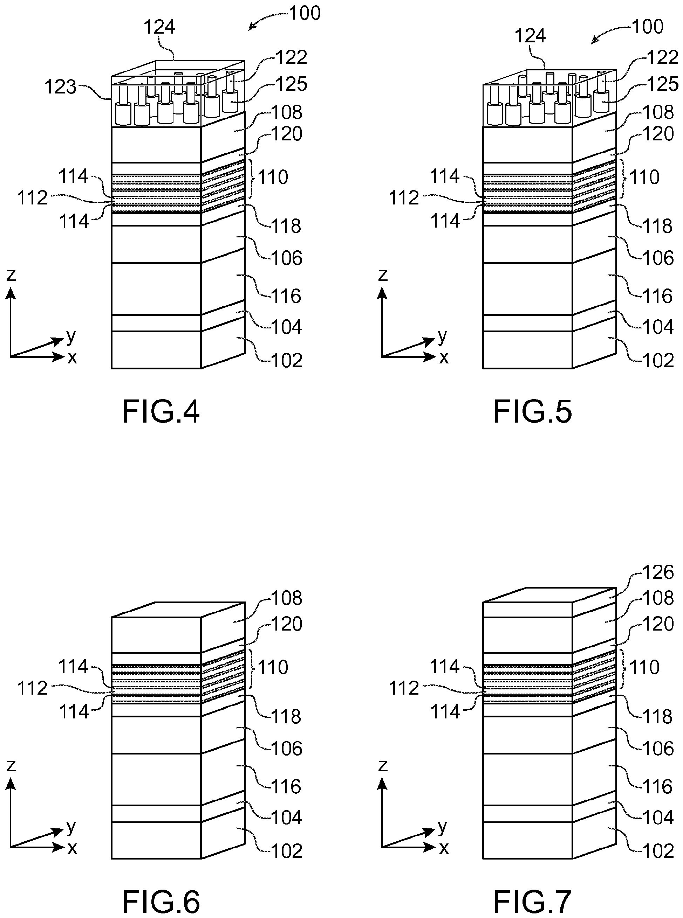

La figure 4 décrite ci-dessous représente une LED 100 à structure hybride comportant des couches de matériaux et des nanofils, selon un troisième mode de réalisation.

Par rapport aux LED 100 selon les premier et deuxième modes de réalisation précédemment décrits, la deuxième couche 108 de la LED 100 selon ce troisième mode de réalisation est gravée sur une partie de son épaisseur, depuis la face de la deuxième couche 108 du côté de laquelle les nanofils 122 sont destinés à être réalisés. Des piliers 125, ou colonnes, dont le nombre et la disposition correspondent au nombre et à la disposition des nanofils 122 réalisés, sont formés dans la partie gravée de la deuxième couche 108. Sur l'exemple de la figure 4, les piliers 125 ont chacun une section, dans un plan parallèle à la face de la deuxième couche 108 depuis laquelle les piliers 125 sont gravés (plan parallèle au plan (X, Y)), de forme circulaire ou ovale. En variante, ces sections des piliers 125 peuvent être de forme différente, par exemple polygonale. Dans le cas de piliers 125 de section circulaire, le diamètre de la section de chaque pilier 125 est par exemple compris entre environ 50 nm et 100 nm. Dans le cas de piliers 125 de section polygonale, la plus grande diagonale de la section de chaque pilier 125 est par exemple comprise entre environ 50 nm et 100 nm. La hauteur de chaque pilier 125 (dimension selon l'axe Z, et qui correspond à la direction d'empilement des différentes couches de la LED 100) est par exemple comprise entre environ 300 nm et 500 nm.

Les nanofils 122 sont réalisés sur les piliers 125. La couche diélectrique 123 est formée autour des nanofils 122 et des piliers 125, et ne recouvre pas les sommets des nanofils 122. La couche de contact ohmique 124 est disposée sur les sommets des nanofils 122 et est reliée électriquement à ces nanofils 122, et repose également sur les parties de la couche diélectrique 123 se trouvant entre les nanofils 122.

La figure 5 décrite ci-dessous représente une LED 100 à structure hybride comportant des couches de matériaux et des nanofils, selon un quatrième mode de réalisation.

Comme dans le troisième mode de réalisation, la LED 100 selon ce quatrième mode de réalisation comporte les piliers 125 formés dans une partie de l'épaisseur de la deuxième couche 108, avec les nanofils 122 formés sur ces piliers 125. Dans ce quatrième mode de réalisation, la couche de contact ohmique 124 recouvre les sommets des nanofils 122 et est également déposée entre les nanofils 122 et entre les piliers 125, sur la partie non gravée de la deuxième couche 108, en recouvrant les flancs latéraux des nanofils 122 et des piliers 125.

En variante de ce troisième mode de réalisation, la couche de contact ohmique 124 peut ne pas recouvrir les sommets des nanofils 122. Dans ce cas, la couche de contact ohmique 124 ne recouvre que les flancs latéraux des nanofils 122 et des piliers 125.

Selon un autre mode de réalisation, la couche diélectrique 123 peut ne recouvrir que les flancs latéraux des piliers 125, et la couche de contact ohmique 124 recouvre dans ce cas les flancs latéraux des nanofils 122 et éventuellement les sommets des nanofils 122. Des variantes de réalisation sont possibles, comme par exemple en ayant la couche diélectrique 123 qui ne recouvre les flancs latéraux des piliers 125 que sur une partie de la hauteur des piliers 125 et la couche de contact ohmique 124 qui recouvre les flancs latéraux des piliers 125 sur le reste de la hauteur des piliers 125 et qui recouvre également les flancs latéraux des nanofils 122, ou bien en ayant la couche diélectrique 123 qui recouvre les flancs latéraux des piliers 125 et les flancs latéraux des nanofils 122 sur une partie de la hauteur des nanofils 122 et la couche de contact ohmique 124 qui recouvre les flancs latéraux des nanofils 122 sur le reste de la hauteur des nanofils 122. Dans tous les cas, la couche de contact ohmique 124 peut recouvrir ou non les sommets des nanofils 122.

En variante des premier, deuxième, troisième et quatrième modes de réalisation précédemment décrits, les dimensions latérales des nanofils 122 à l'interface avec la deuxième couche 108 peuvent être inférieures à celles à l'interface avec la couche de contact ohmique 124. Dans cette variante, les nanofils 122 ont une forme sensiblement conique tronquée telle que la surface des nanofils 122 en contact avec la deuxième couche 108 soit inférieure à la surface des nanofils 122 à leur sommet.

Un premier procédé de réalisation de la LED 100 est décrit ci-dessous en lien avec les figures 6 à 9.

Comme représenté sur la figure 6, les différentes couches de la LED 100 sont réalisées, à partir du substrat 102, par des dépôts successifs, ces dépôts étant avantageusement de type MOCVD. Lors d'un tel dépôt MOCVD, les éléments constitutifs utilisés pour le dépôt du semi-conducteur sont des précurseurs organométalliques, par exemple du triméthylaluminium ou du triéthylaluminium servant de source d'aluminium, de l'ammoniac servant de source d'azote, du triméthylindium ou du triéthylindium servant de source d'indium, et éventuellement du triméthylgallium ou du triéthylgallium servant de source de gallium.

Après la réalisation de la deuxième couche 108, une couche 126 à partir de laquelle un masque dur est destiné à être réalisé, est déposée sur la deuxième couche 108 (voir figure 7). Cette couche 126 comporte par exemple du SiN ou du graphène ou du TiN.

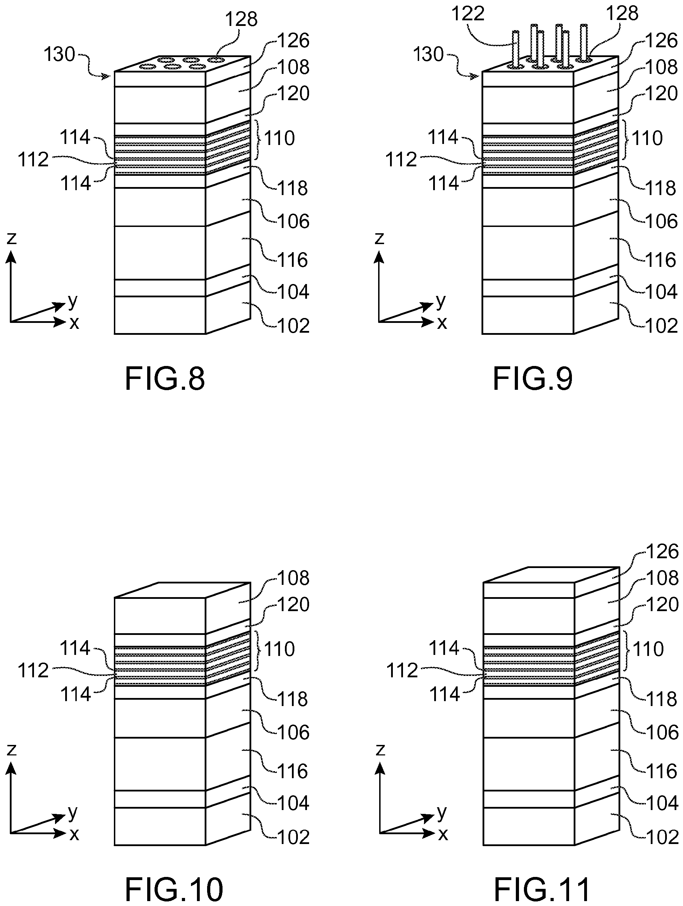

Des étapes de lithographie et de gravure sont ensuite mises en oeuvre pour former, à travers la couche 126, des ouvertures 128 dont le nombre et la disposition correspondent au nombre et à la disposition des nanofils 122 destinés à être réalisés, formant ainsi un masque dur 130 qui servira à la croissance des nanofils 122 (voir figure 8).

Une épitaxie, avantageusement par jet moléculaire, est mise en oeuvre depuis les ouvertures 128 du masque dur 130 afin de former les nanofils 122 (figure 9). Le dopage du matériau des nanofils 122 par des atomes d'indium et de magnésium est mis en oeuvre simultanément à leur croissance. Des détails de mise en oeuvre d'un tel dopage sont décrits dans le document « Mg and In Codoped p-type AIN Nanowires for pn Juntion Realization » de A-M Siladie et al., Nano Letters 2019 19 (12), 8357-8364.

La LED 100 est achevée soit en réalisant tout d'abord la couche diélectrique 123 puis la couche de contact ohmique 124 comme précédemment décrit pour le premier mode de réalisation (voir figure 2), soit en réalisant la couche de contact ohmique 124 comme précédemment décrit pour le deuxième mode de réalisation (voir figure 3). Dans les deux cas, le masque dur 130 peut être conservé ou supprimé avant la réalisation de la couche diélectrique 123 ou de la couche de contact ohmique 124. Le masque dur 130 est de préférence supprimé pour éviter l'absorption de la lumière UV émise par la LED 100.

La couche diélectrique 123 est par exemple réalisée par enduction centrifuge, ou « spin coating ». La couche de contact ohmique 124 est par exemple réalisée par épitaxie par jets moléculaires, ou par évaporation sous vide, ou par pulvérisation cathodique ou par dépôt chimique en phase vapeur.

Un deuxième procédé de réalisation de la LED 100 est décrit ci-dessous en lien avec les figures 10 à 14.

Les étapes du premier procédé de réalisation de la LED 100 précédemment décrites en lien avec les figures 6 à 8 sont tout d'abord mises en oeuvre. Ces étapes sont représentées sur les figures 10 à 12.

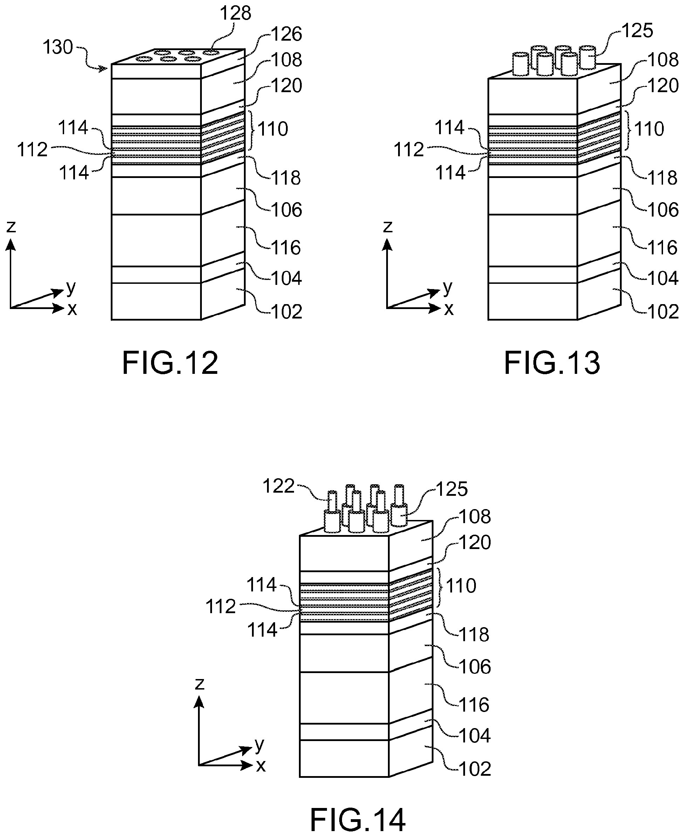

Le masque dur 130 est ensuite utilisé pour graver, dans une partie de l'épaisseur de la deuxième couche 108 et depuis la face de la deuxième couche 108 du côté de laquelle les nanofils 122 sont destinés à être réalisés (qui correspond à la face de la deuxième couche 108 sur laquelle le masque dur 130 est réalisé), les piliers 125 dont le nombre et la disposition correspondent au nombre et à la disposition des ouvertures 128. Le masque dur 130 est ensuite retiré (voir figure 13).

Une épitaxie, avantageusement par jet moléculaire, est mise en oeuvre pour faire croître sur les sommets des piliers 125 les nanofils 122 (figure 14). Le dopage du matériau des nanofils 122 par des atomes d'indium et de magnésium est mis en oeuvre simultanément à leur croissance, de manière analogue à ce qui est précédemment décrit dans le premier procédé de réalisation.

La LED 100 est achevée soit en réalisant tout d'abord la couche diélectrique 123 puis la couche de contact ohmique 124 comme précédemment décrit pour le troisième mode de réalisation (voir figure 4), soit en réalisant la couche de contact ohmique 124 comme précédemment décrit pour le quatrième mode de réalisation (voir figure 5).

En outre, pour les différents procédés de réalisation décrits ci-dessus, les nanofils 122 peuvent être réalisés tels que leurs dimensions latérales à l'interface avec la deuxième couche 108 soient inférieures à celles à leur sommet. Des détails de mise en oeuvre pour former de tels nanofils sont décrits dans le document « Mg and In Codoped p-type AIN Nanowires for pn Juntion Realization » de A-M Siladie et al., Nano Letters 2019 19 (12), 8357-8364.

Dans les procédés de réalisation décrits ci-dessus, les nanofils 122 sont réalisés dans un équipement différent de celui utilisé pour réaliser les autres couches de la LED 100. Pour faciliter le passage d'un équipement à l'autre, par exemple pour le passage d'un équipement de dépôt MOCVD servant à réaliser les couches de la LED 100 à un équipement d'épitaxie MBE utilisé pour réaliser les nanofils 122, il est possible de déposer sur la structure réalisée par dépôt MOCVD, avant de la sortir de l'équipement de dépôt MOCVD, une couche de protection par exemple à base de GaN. Une fois la structure dans l'équipement d'épitaxie MBE, la couche de protection est supprimée et les nanofils 122 sont réalisés.

## Revendications

1. Diode électroluminescente (100) comportant au moins :
- une première couche (106) d'Al_{X1}Ga_{(1-X1-Y1)}In_{Y1}N dopé n, avec X1 > 0 et X1+Y1 ≤ 1 ;
- une deuxième couche (108) d'Al_{X2}Ga_{(1-X2-Y2)}In_{Y2}N dopé p, avec X2 > 0 et X2+Y2 ≤ 1 ;
- une zone active (110) disposée entre les première et deuxième couches (106, 108) et comprenant au moins une structure émissive à multi-puits quantiques (112, 114) ; et
- une couche de contact ohmique (124),
et **caractérisée en ce que** la diode électroluminescente comporte en outre :
- des nanofils (122) à base d'AIN dopé p par des atomes d'indium et de magnésium, disposés sur la deuxième couche (108) ;
et **en ce que** la couche de contact ohmique (124) est en contact avec les nanofils (122).

2. Diode électroluminescente (100) selon la revendication 1, comportant en outre une couche diélectrique (123) recouvrant des flancs latéraux des nanofils (122) et sur laquelle repose la couche de contact ohmique (124).

3. Diode électroluminescente (100) selon la revendication 1, dans laquelle la couche de contact ohmique (124) recouvre des flancs latéraux des nanofils (122) et/ou des sommets des nanofils.

4. Diode électroluminescente (100) selon l'une des revendications précédentes, dans laquelle la couche de contact ohmique (124) comporte du diamant.

5. Diode électroluminescente (100) selon l'une des revendications précédentes, dans laquelle la concentration atomique d'indium dans les nanofils (122) est comprise entre environ 10¹⁷ et 10²¹ atomes/cm³ et/ou dans laquelle la concentration atomique de magnésium dans les nanofils (122) est comprise entre environ 10¹⁸ et 10²¹ atomes/cm³.

6. Diode électroluminescente (100) selon l'une des revendications précédentes, dans laquelle au moins une partie de l'épaisseur de la deuxième couche (108) est gravée et forme des piliers (125) sur lesquels les nanofils (122) sont disposés.

7. Diode électroluminescente (100) selon l'une des revendications précédentes, dans laquelle la structure émissive à multi-puits quantiques (112, 114) comporte de l'Al_{X3}Ga_{(1-X3)}N, avec X3 compris entre environ 0 et 1.

8. Diode électroluminescente (100) selon l'une des revendications précédentes, comportant en outre une troisième couche (116) d'Al_{X4}Ga_{(1-X4-Y4)}In_{Y4}N non dopé intentionnellement, avec X4 > 0 et X4+Y4 ≤ 1, telle que la première couche (106) soit disposée entre la zone active (110) et la troisième couche (116).

9. Diode électroluminescente (100) selon l'une des revendications précédentes, dans laquelle les dimensions latérales des nanofils (122) à l'interface avec la deuxième couche (108) sont inférieures à celles à l'interface avec la couche de contact ohmique (124).

10. Procédé de réalisation d'une diode électroluminescente (100), comportant au moins :
- réalisation d'une première couche (106) d'Al_{X1}Ga_{(1-X1-Y1)}In_{Y1}N dopé n, avec X1 > 0 et X1+Y1 ≤ 1 ;
- réalisation d'une zone active (110) disposée sur la première couche (106) et comprenant au moins une structure émissive à multi-puits quantiques (112, 114) ;
- réalisation d'une deuxième couche (108) d'Al_{X2}Ga_{(1-X2-Y2)}In_{Y2}N dopé p, avec X2 > 0 et X2+Y2 ≤ 1, sur la zone active (110) ;
- réalisation de nanofils (122) à base d'AIN dopé p par des atomes d'indium et de magnésium, sur la deuxième couche (108) ;
- réalisation d'une couche de contact ohmique (124) disposée en contact avec les nanofils (122).

11. Procédé selon la revendication 10, dans lequel la première couche (106), la zone active (110) et la deuxième couche (108) sont réalisées par des dépôts de type MOCVD, et dans lequel les nanofils (122) sont réalisés par épitaxie par jets moléculaires.

12. Procédé selon l'une des revendications 10 ou 11, dans lequel la couche de contact ohmique (124) est réalisée par épitaxie par jets moléculaires ou par évaporation sous vide ou par pulvérisation cathodique ou par dépôt chimique en phase vapeur.

13. Procédé selon l'une des revendications 10 à 12, dans lequel la réalisation des nanofils (122) comporte la mise en oeuvre des étapes suivantes :
- réalisation, sur la deuxième couche (108), d'un masque dur (130) traversé par des ouvertures (128) dont le nombre et la disposition correspondent au nombre et à la disposition des nanofils (122) destinés à être réalisés ;
- réalisation des nanofils (122) par épitaxie depuis les ouvertures (128) du masque dur (130), sur la face de la deuxième couche (108) sur laquelle le masque dur (130) est disposé.

14. Procédé selon l'une des revendications 10 à 12, dans lequel la réalisation des nanofils (122) comporte la mise en oeuvre des étapes suivantes :
- gravure mise en oeuvre dans au moins une partie de l'épaisseur de la deuxième couche (108) et depuis une face de la deuxième couche (108) du côté de laquelle les nanofils (122) sont destinés à être réalisés, formant des piliers (125) dont le nombre et la disposition correspondent au nombre et à la disposition des nanofils (122) destinés à être réalisés ;
- réalisation des nanofils (122) par épitaxie sur les piliers (125) formés dans la deuxième couche (108).

## Patentansprüche

1. Lichtemittierende Diode (100), die mindestens Folgendes aufweist:
- eine erste Schicht (106) aus n-dotiertem Al_{X1}Ga_{(1-X1-Y1)}In_{Y1}N, wobei X1 > 0 und X1+Y1 ≤ 1;
- eine zweite Schicht (108) aus p-dotiertem Al_{X2}Ga_{(1-X2-Y2})In_{Y2}N, wobei X2 > 0 und X2+Y2 < 1;
- einen aktiven Bereich (110), der zwischen der ersten und der zweiten Schicht (106, 108) angeordnet ist und mindestens eine emittierende Struktur mit Mehrfachquantentöpfen (112, 114) umfasst; und
- eine ohmsche Kontaktschicht (124),
und **dadurch gekennzeichnet, dass** die lichtemittierende Diode ferner Folgendes aufweist:
- Nanodrähte (122) auf Basis von mit Indium- und Magnesiumatomen p-dotiertem AIN, die auf der zweiten Schicht (108) angeordnet sind;
und dadurch, dass die ohmsche Kontaktschicht (124) in Kontakt mit den Nanodrähten (122) ist.

2. Lichtemittierende Diode (100) nach Anspruch 1, die ferner eine dielektrische Schicht (123) aufweist, die seitliche Flanken der Nanodrähte (122) bedeckt und auf der die ohmsche Kontaktschicht (124) aufliegt.

3. Lichtemittierende Diode (100) nach Anspruch 1, wobei die ohmsche Kontaktschicht (124) seitliche Flanken der Nanodrähte (122) und/oder Oberseiten der Nanodrähte bedeckt.

4. Lichtemittierende Diode (100) nach einem der vorhergehenden Ansprüche, wobei die ohmsche Kontaktschicht (124) Diamant aufweist.

5. Lichtemittierende Diode (100) nach einem der vorhergehenden Ansprüche, wobei die atomare Konzentration von Indium in den Nanodrähten (122) zwischen etwa 10¹⁷ und 10²¹ Atomen/cm³ beträgt, und/oder wobei die atomare Konzentration von Magnesium in den Nanodrähten (122) zwischen etwa 10¹⁸ und 10²¹ Atomen/cm³ beträgt.

6. Lichtemittierende Diode (100) nach einem der vorhergehenden Ansprüche, wobei mindestens ein Teil der Dicke der zweiten Schicht (108) geätzt ist und Säulen (125) bildet, auf denen die Nanodrähte (122) angeordnet sind.

7. Lichtemittierende Diode (100) nach einem der vorhergehenden Ansprüche, wobei die emittierende Struktur mit Mehrfachquantentöpfen (112, 114) Al_{X3}Ga_{(1-X3)}N aufweist, wobei X3 zwischen etwa 0 und 1 beträgt.

8. Lichtemittierende Diode (100) nach einem der vorhergehenden Ansprüche, die ferner eine dritte Schicht (116) aus nicht absichtlich dotiertem Al_{X4}Ga_{(1-X4-Y4)}In_{Y4}N, wobei X4 > 0 und X4+Y4 ≤ 1, so dass die erste Schicht (106) zwischen dem aktiven Bereich (110) und der dritten Schicht (116) angeordnet ist.

9. Lichtemittierende Diode (100) nach einem der vorhergehenden Ansprüche, wobei die lateralen Abmessungen der Nanodrähte (122) an einer Grenzfläche mit der zweiten Schicht (108) kleiner sind als diejenigen an einer Grenzfläche mit der ohmschen Kontaktschicht (124).

10. Verfahren zum Herstellen einer lichtemittierenden Diode (100), das Folgendes aufweist:
- Herstellen einer ersten Schicht (106) aus n-dotiertem Al_{X1}Ga_{(1-X1-Y1)}In_{Y1}N, wobei X1 > 0 und X1+Y1 ≤ 1;
- Herstellen eines aktiven Bereichs (110), der auf der ersten Schicht (106) angeordnet ist und mindestens eine emittierende Struktur mit Mehrfachquantentöpfen (112, 114) umfasst;
- Herstellen einer zweiten Schicht (108) aus p-dotiertem Al_{X2}Ga_{(1-X2-Y2})In_{Y2}N, wobei X2 > 0 und X2+Y2 ≤ 1, auf dem aktiven Bereich (110);
- Herstellen von Nanodrähten (122) auf Basis von mit Indium- und Magnesiumatomen p-dotiertem AIN, auf der zweiten Schicht (108); und
- Herstellen einer ohmschen Kontaktschicht (124), die in Kontakt mit den Nanodrähten (122) angeordnet ist.

11. Verfahren nach Anspruch 10, wobei die erste Schicht (106), der aktive Bereich (110) und die zweite Schicht (108) durch Abscheidungen vom MOCVD-Typ hergestellt werden, und wobei die Nanodrähte (122) durch Molekularstrahlepitaxie hergestellt werden.

12. Verfahren nach einem der Ansprüche 10 oder 11, wobei die ohmsche Kontaktschicht (124) durch Molekularstrahlepitaxie oder durch Vakuumverdampfung oder durch Sputtern oder durch chemische Gasphasenabscheidung hergestellt wird.

13. Verfahren nach einem der Ansprüche 10 bis 12, wobei das Herstellen der Nanodrähte (122) das Durchführen der folgenden Schritte aufweist:
- Herstellen einer Hartmaske (130), die von Öffnungen (128) durchdrungen ist, deren Anzahl und Anordnung der Anzahl und der Anordnung der herzustellenden Nanodrähte (122) entspricht, auf der zweiten Schicht (108);
- Herstellen der Nanodrähte (122) durch Epitaxie aus den Öffnungen (128) der Hartmaske (130) auf der Fläche der zweiten Schicht (108), auf der die Hartmaske (130) angeordnet ist.

14. Verfahren nach einem der Ansprüche 10 bis 12, wobei das Herstellen der Nanodrähte (122) das Durchführen der folgenden Schritte aufweist:
- Ätzen, das in mindestens einem Teil der Dicke der zweiten Schicht (108) und von einer Fläche der zweiten Schicht (108) aus durchgeführt wird, auf deren Seite die Nanodrähte (122) hergestellt werden sollen, wodurch Säulen (125) gebildet werden, deren Anzahl und Anordnung der Anzahl und der Anordnung der herzustellenden Nanodrähte (122) entspricht;
- Herstellen der Nanodrähte (122) durch Epitaxie auf den Säulen (125), die in der zweiten Schicht (108) gebildet werden.

## Claims

1. Light-emitting diode (100) including at least:
- a first layer (106) of n-doped Al_{X1}Ga_{(1-X1-Y1)}In_{Y1}N, with X1 > 0 and X1+Y1 ≤ 1;
- a second layer (108) of p-doped Al_{X2}Ga_{(1-X2-Y2})In_{Y2}N, with X2 > 0 and X2+Y2 ≤ 1;
- an active area (110) disposed between the first and second layers (106, 108) and comprising at least one multi-quantum well emissive structure (112, 114); and
- an ohmic contact layer (124),
and **characterized in that** the light-emitting diode also comprises:
- nanowires (122) based on AIN p-doped with indium and magnesium atoms, disposed on the second layer (108);
and **in that** the ohmic contact layer (124) is in contact with the nanowires (122).

2. Light-emitting diode (100) according to claim 1, further including a dielectric layer (123) covering lateral flanks of the nanowires (122) and on which the ohmic contact layer (124) rests.

3. Light-emitting diode (100) according to claim 1, wherein the ohmic contact layer (124) covers lateral flanks of the nanowires (122) and/or tops of the nanowires.

4. Light-emitting diode (100) according to one of the preceding claims, wherein the ohmic contact layer (124) includes diamond.

5. Light-emitting diode (100) according to one of the preceding claims, wherein the atomic concentration of indium in the nanowires (122) is comprised between about 10¹⁷ and 10²¹ atoms/cm³ and/or wherein the atomic concentration of magnesium in the nanowires (122) is comprised between about 10¹⁸ and 10²¹ atoms/cm³.

6. Light-emitting diode (100) according to one of the preceding claims, wherein at least one portion of the thickness of the second layer (108) is etched and forms pillars (125) on which the nanowires (122) are disposed.

7. Light-emitting diode (100) according to one of the preceding claims, wherein the multi-quantum well emissive structure (112, 114) includes Al_{X3}Ga_{(1-X3)}N, with X3 comprised between about 0 and 1.

8. Light-emitting diode (100) according to one of the preceding claims, further including a third layer (116) of not intentionally doped Al_{X4}Ga_{(1-X4-Y4)}In_{Y4}N, with X4 > 0 and X4+Y4 ≤ 1, such that the first layer (106) is disposed between the active area (110) and the third layer (116).

9. Light-emitting diode (100) according to one of the preceding claims, wherein the lateral dimensions of the nanowires (122) at the interface with the second layer (108) are smaller than those at the interface with the ohmic contact layer (124).

10. Method for producing a light-emitting diode (100), including at least:
- producing a first layer (106) of n-doped Al_{X1}Ga_{(1-X1-Y1)}In_{Y1}N, with X1 > 0 and X1+Y1 ≤ 1;
- producing an active area (110) disposed on the first layer (106) and comprising at least one multi-quantum well emissive structure (112, 114);
- producing a second layer (108) of p-doped Al_{X2}Ga_{(1-X2-Y2})In_{Y2}N, with X2 > 0 and X2+Y2 ≤ 1, on the active area (110);
- producing nanowires (122) based on AIN p-doped with indium and magnesium atoms, on the second layer (108);
- producing an ohmic contact layer (124) disposed in contact with the nanowires (122).

11. Method according to claim 10, wherein the first layer (106), the active area (110) and the second layer (108) are produced by MOCVD type depositions, and wherein the nanowires (122) are produced by molecular beam epitaxy.

12. Method according to one of claims 10 or 11, wherein the ohmic contact layer (124) is produced by molecular beam epitaxy or by vacuum evaporation or by cathode sputtering or by chemical vapour deposition.

13. Method according to one of claims 10 to 12, wherein the production of the nanowires (122) includes the implementation of the following steps:
- producing, on the second layer (108), a hard mask (130) through which openings (128), whose number and arrangement correspond to the number and arrangement of the nanowires (122) which are intended to be produced, pass;
- producing the nanowires (122) by epitaxy from the openings (128) of the hard mask (130), on the face of the second layer (108) on which the hard mask (130) is disposed.

14. Method according to one of claims 10 to 12, wherein the production of the nanowires (122) includes the implementation of the following steps:
- etching implemented in at least one portion of the thickness of the second layer (108) and from a face of the second layer (108) on the side of which the nanowires (122) are intended to be produced, forming pillars (125) whose number and arrangement correspond to the number and arrangement of the nanowires (122) which are intended to be produced;
- producing the nanowires (122) by epitaxy on the pillars (125) which are formed in the second layer (108).
